# EUROPEAN PATENT APPLICATION

(11) **EP 4 629 762 A1**
(43) Date of publication of application: **08.10.2025**
(21) Application number: 23895848.2
(22) Date of filing: 11.05.2023
(51) Int. Cl.: H05K 7/20

(54) **HEAT DISSIPATION ELEMENT AND THERMOSIPHON RADIATOR**

(30) Priority: 28.11.2022 CN 202211501414
(71) Applicant: Shenzhen Envicool Technology Co., Ltd, Shenzhen, Guangdong 518000 (CN)
(72) Inventor: WANG, Ye, Shenzhen, Guangdong 518000 (CN); WEI, Lichuan, Shenzhen, Guangdong 518000 (CN)
(74) Representative: Torggler & Hofmann Patentanwälte - Innsbruck
(86) International application number: PCT/CN2023/093448
(87) International publication number: WO 2024/113682

(57) **Abstract**

Disclosed in the embodiments of the present application are a heat dissipation element and a thermosiphon radiator, which are used in the field of electronic heat dissipation. The heat dissipation element comprises a substrate and a cover plate which are connected to each other to form an accommodating cavity, wherein the substrate is provided with a first plate surface and a second plate surface opposite to each other, and the projection of a liquid surface of a liquid phase change working medium accommodated in the accommodating cavity on a plane in the direction of gravity is not higher than the uppermost portion of the projection of a heat source mounted on the second plate surface; and a capillary layer provided in the accommodating cavity, wherein the bottommost portion of the projection of the capillary layer on a plane in the direction of gravity is not higher than the bottommost portion of the projection of the heat source mounted on the second plate surface, and the uppermost portion of the projection of the capillary layer on the plane in the direction of gravity is not lower than the uppermost portion of the projection of the heat source mounted on the second plate surface; the capillary layer is used for sucking up the liquid phase change working medium for phase change heat transfer with the heat source, and the capillary layer is provided with a steam channel, wherein the steam channel allows a gaseous phase change working medium generated by means of phase change to be discharged out of the capillary layer, thereby expanding a condensation space, and improving the performance of the thermosiphon radiator.

## Description

The application claims priority to Chinese Patent Application No. 202211501414.3, titled "HEAT DISSIPATION ELEMENT AND THERMOSIPHON RADIATOR", filed on November 28, 2022 with the China National Intellectual Property Administration, which is incorporated herein by reference in its entirety.

### FIELD

The application relates to the technical field of electronic heat dissipation, and in particular to a heat dissipation element and a thermosiphon radiator including the heat dissipation element.

### BACKGROUND

A phase-change working medium inside a thermosiphon radiator circulates entirely by gravity. In other words, a liquid level of a liquid phase-change working medium inside the thermosiphon radiator is higher than an upper interface of a heat source in a vertical direction, to allow the heat of the heat source to be fully absorbed through heat transfer of phase change.

In the process of implementation of the application, it is found that there are at least the following problems in the conventional technology.

The liquid level of the liquid phase-change working medium inside a conventional thermosiphon radiator is higher than the upper interface of the heat source in the vertical direction, so that a part of the space that can be used as a condensation area is occupied, thereby limiting the performance of the conventional thermosiphon radiator.

### SUMMARY

A heat dissipation element is provided according to an embodiment of the application. The heat dissipation element is applied to the thermosiphon radiator, and can improve the performance of the thermosiphon radiator.

A thermosiphon radiator including the heat dissipation element is further provided according to another embodiment of the application.

In a first aspect, a heat dissipation element is provided according to an embodiment of the application. The heat dissipation element is applied to a thermosiphon radiator and includes: a substrate and a cover plate connected to each other to form an accommodation cavity, and a capillary layer arranged in the accommodation cavity.

The accommodation cavity is configured to accommodate a phase-change working medium and be communicated with a working-medium channel in a fin of the thermosiphon radiator.

The substrate has a first plate surface and a second plate surface opposite to each other, the first plate surface is configured to form the accommodation cavity, the second plate surface is configured to allow a heat source to be mounted thereon, and a projection of a liquid level of a liquid phase-change working medium accommodated in the accommodation cavity on a plane extending along a direction of gravity is not higher than a top of a projection of the heat source mounted on the second plate surface on the plane extending along the direction of gravity.

A bottom of a projection of the capillary layer on the plane extending along the direction of gravity is not higher than a bottom of the projection of the heat source mounted on the second plate surface on the plane extending along the direction of gravity, and a top of the projection of the capillary layer on the plane extending along the direction of gravity is not lower than the top of the projection of the heat source mounted on the second plate surface on the plane extending along the direction of gravity.

The capillary layer is configured to suck the liquid phase-change working medium to perform phase-change heat transfer with the heat source, a steam channel is provided on the capillary layer, and the steam channel is configured to discharge a gaseous phase-change working medium generated by phase change from the capillary layer.

The heat dissipation element according to the embodiment of the application includes: the substrate and the cover plate connected to each other to form the accommodation cavity, and the capillary layer arranged in the accommodation cavity. The substrate has the first plate surface and the second plate surface opposite to each other, the first plate surface is configured to form the accommodation cavity, the second plate surface is configured to allow the heat source to be mounted thereon, and the projection of the liquid level of the liquid phase-change working medium accommodated in the accommodation cavity on the plane extending along the direction of gravity is not higher than the top of the projection of the heat source mounted on the second plate surface on the plane extending along the direction of gravity. The bottom of the projection of the capillary layer on the plane extending along the direction of gravity is not higher than the bottom of the projection of the heat source mounted on the second plate surface on the plane extending along the direction of gravity, and the top of the projection of the capillary layer on the plane extending along the direction of gravity is not lower than the top of the projection of the heat source mounted on the second plate surface on the plane extending along the direction of gravity. The capillary layer is configured to suck the liquid phase-change working medium to perform phase-change heat transfer with the heat source, the steam channel is provided on the capillary layer, and the steam channel is configured to discharge the gaseous phase-change working medium generated by phase change from the capillary layer. Since the projection of the liquid level of the liquid phase-change working medium accommodated in the accommodation cavity on the plane extending along the direction of gravity is not higher than the top of the projection of the heat source mounted on the second plate surface on the plane extending along the direction of gravity, the liquid phase-change working medium does not occupy the space that can be used as the condensation area. Therefore, in the thermosiphon radiator to which the heat dissipation element according to the embodiment of the application is applied, the space that can be used as the condensation area can be fully utilized, expanding the condensation space of the thermosiphon radiator, thereby improving the performance of the thermosiphon radiator.

In some embodiments of the heat dissipation element, the bottom of the projection of the capillary layer on the plane extending along the direction of gravity is lower than the bottom of the projection of the heat source mounted on the second plate surface on the plane extending along the direction of gravity; and
the steam channel is arranged on a part, a projection of which on the plane extending along the direction of gravity is not lower than the bottom of the projection of the heat source mounted on the second plate surface on the plane extending along the direction of gravity, of the capillary layer.

In some embodiments of the heat dissipation element, the bottom of the projection of the capillary layer on the plane extending along the direction of gravity is flush with the bottom of the projection of the heat source mounted on the second plate surface on the plane extending along the direction of gravity; and
a bottom of the capillary layer abuts against a bottom of the accommodation cavity in the direction of gravity.

In some embodiments of the heat dissipation element, the steam channel is arranged on one side, facing towards the first plate surface, of the capillary layer.

In some embodiments of the heat dissipation element, the heat dissipation element further includes a filling tube;
one end of the filling tube is in communication with the accommodation cavity, and the other end of the filling tube is configured to be communicated with an exterior of the heat dissipation element; and
the filling tube is configured to vacuumize the accommodation cavity and the working-medium channel and inject the liquid phase-change working medium into the accommodation cavity and the working-medium channel.

In some embodiments of the heat dissipation element, communication holes are formed in the cover plate;
the communication holes are configured to allow the accommodation cavity to be communicated with the working-medium channel to allow the gaseous phase-change working medium to be diffused into the working-medium channel through the communication holes, and to allow the liquid phase-change working medium condensed in the working-medium channel to flow back to the accommodation cavity through the communication holes.

In some embodiments of the heat dissipation element, a support structure is arranged on the substrate;
the support structure is arranged on a part, a projection of which on the plane extending along the direction of gravity is higher than the top of the projection of the capillary layer on the plane extending along the direction of gravity, of the first plate surface;
the support structure includes multiple support columns spaced apart; and
one end of each of the multiple support columns is connected to the first plate surface, and the other end of each of the multiple support columns is connected to the cover plate to support the accommodation cavity.

In some embodiments of the heat dissipation element, a cross section of the support column is circular-shaped or polygonal-shaped.

In some embodiments of the heat dissipation element, the capillary layer includes any one of: a capillary product formed by sintering metal powders with different particle sizes, a capillary product formed by sintering multiple layers of mesh structures, a capillary product formed by 3D metal printing, or a metal foam.

In some embodiments of the heat dissipation element, the liquid phase-change working medium includes any one of: an R134a working medium, an R22 working medium, an R1233zd working medium, or a fluorinated liquid.

In a second aspect, a thermosiphon radiator is provided according to another embodiment of the application. The thermosiphon radiator includes a fin having a working-medium channel and the heat dissipation element according to any one of the embodiments of the first aspect;

the fin is arranged on one side, away from the accommodation cavity, of the cover plate, and the working-medium channel is in communication with the connecting holes.

Since the thermosiphon radiator according to the embodiment of the application has the heat dissipation element according to any one of the embodiments of the first aspect, it is apparent that the thermosiphon radiator has the same technical effects as those of the heat dissipation element according to the embodiment of the application.

In some embodiments of the thermosiphon radiator, the substrate and the capillary layer, the substrate and the cover plate, and the cover plate and the fin are fixed to each other by welding.

### BRIEF DESCRIPTION OF THE DRAWINGS

In order to more clearly illustrate the technical solutions in the embodiments of the application, drawings used in the description of the embodiments are briefly introduced below. Apparently, the drawings in the following description are only some embodiments described in the application. For those skilled in the art, other drawings can also be obtained based on the drawings.
Figure 1 is a schematic structural diagram of a radiator according to some embodiments of the application;
Figure 2 is a schematic structural diagram of a radiator according to certain embodiments of the application;
Figure 3 is a schematic structural diagram of a capillary layer according to some embodiments of the application;
Figure 4 is a schematic structural diagram of a capillary layer only including a steam channel according to some embodiment of the application;
Figure 5 is a schematic diagram of an assembled radiator according to some embodiments of the application; and
Figure 6 is a schematic diagram of an assembled radiator according to certain embodiments of the application.

### DETAILED DESCRIPTION OF THE EMBODIMENTS

In order to enable those skilled in the art to better understand the solutions of the application, the technical solutions in the embodiments of the application will be clearly and completely described below in conjunction with the accompanying drawings. Apparently, the described embodiments are only a part of the embodiments of the application, rather than all embodiments. All other embodiments obtained by those skilled in the art based on the embodiments in the application without creative efforts fall within the scope of protection of the application.

In the description of the embodiments of the application, it should be noted that, orientations or positional relationships indicated by terms such as "center", "up", "down", "left", "right", "vertical", "horizontal", "inside" and "outside" are based on the orientations or position relationships shown in the drawings, and are only for the convenience of describing the embodiments of the application and simplifying the description, rather than indicating or implying that devices or elements referred to must have specific orientations, or must be constructed and operated in specific orientations, and thus should not be understood as limitations to the embodiments of the application.

In the description of the embodiments of the application, it should be noted that, unless otherwise clearly specified and limited, terms "mounting", "joint" and "connection" should be understood in a broad sense, for example, a fixed connection, a detachable connection, or an integral connection; a mechanical connection or an electric connection; a direct connection, or an indirect connection through an intermediary, or internal connection of two elements. For those skilled in the art, the specific meanings of the terms in the embodiments of the application may be understood based on specific situations.

With the development of electronic technology and communication technology, the heat dissipation efficiency of radiators is required to be improved. A conventional radiator made of die-cast aluminum is heavy and has low heat dissipation efficiency, and is difficult to meet the current heat dissipation requirements.

The conventional methods for improving the efficiency of a radiator include improving the efficiency of a heat dissipation fin, and optimizing the structure of the radiator to improve the convective heat transfer coefficient. Improving the efficiency of the heat dissipation fin is direct, fast and effective. Research on materials and composite materials with high thermal conductivity coefficients to replace cast aluminum fins has achieved good results, for example, graphene-metal composite materials and spraying graphene coating on a surface. Heat transfer of phase change is implemented as improving heat dissipation capacity through latent heat and gas-liquid circulation of a phase-change working medium, and is currently widely used in the field of electronic heat dissipation, such as a vapor chamber, a heat pipe, a blow-up plate fin, and a thermosiphon radiator.

However, a phase-change working medium inside a thermosiphon radiator circulates entirely by gravity. In other words, a liquid level of a liquid phase-change working medium inside the thermosiphon radiator should be higher than an upper interface (a top) of a heat source in a vertical direction (a direction of gravity), to allow the heat of the heat source to be fully absorbed through heat transfer of phase change. In this way, the liquid level of the liquid phase-change working medium inside the thermosiphon radiator cannot be lower than the upper interface of the heat source in the vertical direction (the direction of gravity). If the liquid level of the liquid phase-change working medium inside the thermosiphon radiator is lower than the upper interface (top) of the heat source in the vertical direction (the direction of gravity), the heat of the heat source cannot be fully absorbed through heat transfer of phase change. In addition, the liquid phase-change working medium accommodated inside the thermosiphon radiator affects the range of a condensation area. The more the liquid phase-change working medium accommodated inside the thermosiphon radiator is, the smaller the space that can be used as the condensation area is, which means that the performance of the thermosiphon radiator is worse. Since the liquid level of the liquid phase-change working medium inside the thermosiphon radiator is higher than the upper interface (top) of the heat source in the vertical direction (the direction of gravity), a part of the space that can be used as the condensation area is occupied. That is, a part, higher than the upper interface (top) of the heat source, of the liquid phase-change working medium occupies the part of the space that can be used as the condensation area, so that the space that can be used as the condensation area in the thermosiphon radiator is not fully utilized, limiting the performance of the conventional thermosiphon radiator. Based on this, a heat dissipation element and a thermosiphon radiator are provided according to the embodiments of the application, and the performance of the thermosiphon radiator can be improved.

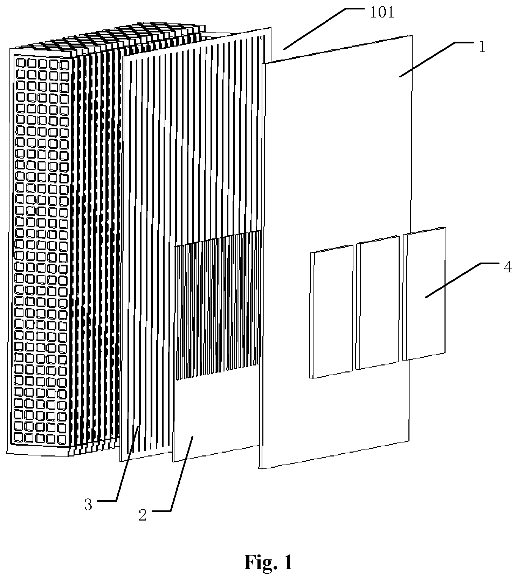

Firstly, a heat dissipation element is provided according to an embodiment of the application, the heat dissipation element is applied to a thermosiphon radiator, and as shown in Figure 1, the details are as follows.

The heat dissipation element according to the embodiment of the application at least includes: a substrate 1 and a cover plate 3 connected to each other to form an accommodation cavity 101. The accommodation cavity 101 is configured to accommodate a phase-change working medium and be communicated with a working-medium channel in a fin of the thermosiphon radiator. It can be understood that, the accommodation cavity 101 is mainly configured for the flow and the phase change of the phase-change working medium. The phase-change working medium includes a liquid phase-change working medium and a gaseous phase-change working medium, that is, there are the liquid phase-change working medium and the gaseous phase-change working medium generated by the phase change of the liquid phase-change working medium in the accommodation cavity 101. The gaseous phase-change working medium in the accommodation cavity 101 may flow into the working-medium channel in the fin of the thermosiphon radiator to be condensed and become the liquid phase-change working medium. The substrate 1 has a first plate surface and a second plate surface opposite to each other. It can be understood that, the first plate surface is a surface, closer to (or facing towards) the cover plate 3, of the substrate 1, and the second plate surface is a surface, further away from (or away from) the cover plate 3, of the substrate 1. The first plate surface is configured to form the accommodation cavity, the second plate surface is configured to allow a heat source 4 to be mounted thereon, and a projection of a liquid level of the liquid phase-change working medium accommodated in the accommodation cavity 101 on a plane extending along a direction of gravity (or the vertical direction, i.e. a direction perpendicular to the ground) is not higher than a top of a projection of the heat source 4 mounted on the second plate surface on the plane extending along the direction of gravity. It can be understood that, the projection of the liquid level of the liquid phase-change working medium in the accommodation cavity 101 may be lower than a bottom of the projection of the heat source 4, or may also be higher than the bottom of the projection of the heat source 4 and lower than the top of the projection of the heat source 4, or may be flush with the top of the projection of the heat source 4, which is not limited here. In an embodiment, the projection of the liquid level of the liquid phase-change working medium in the accommodation cavity 101 on the plane extending along the direction of gravity (or the vertical direction, i.e. the direction perpendicular to the ground) is lower than the top of the projection of the heat source 4 on the plane extending along the direction of gravity. In this way, the normal operation of the thermosiphon radiator is guaranteed, the filling amount of the liquid phase-change working medium is reduced, the thermosiphon radiator is lighter in weight, in addition, the space that can be used as the condensation area in the thermosiphon radiator is not occupied, and thus the condensation space can be enlarged, thereby improving the performance of the thermosiphon radiator. The liquid phase-change working medium (phase-change working medium) is any fluid that can perform gas-liquid phase change under the working condition of the radiator, and may be an R134a working medium (or refrigerant), an R22 working medium (or refrigerant), an R1233zd working medium (or refrigerant), or a fluorinated liquid, which is not limited here.

The heat dissipation element further includes a capillary layer 2, which is arranged in the accommodation cavity 101. The capillary layer 2 has a capillary force. Specifically, the structure of the capillary layer 2 may be a capillary product formed by sintering metal powders with different particle sizes, thereby forming a continuous and irregular porous medium to provide the capillary force required in the substrate. Alternatively, the structure of the capillary layer may be a capillary product formed by sintering multiple layers of mesh structures, and capillary channels are formed between the multiple layers of meshes to provide the capillary force. Alternatively, the capillary layer 2 may be a capillary product formed by 3D metal printing or a metal foam, that is, the capillary layer 2 includes any one of: a capillary product formed by sintering metal powders with different particle sizes, a capillary product formed by sintering multiple layers of mesh structures, a capillary product formed by 3D metal printing, and a metal foam, which is not limited here. The substrate 1, the capillary layer 2, and the cover plate 3 are oppositely arranged in the vertical direction (or the direction of gravity). It can be understood that the substrate 1, the capillary layer 2, and the cover plate 3 may be arranged parallel to each other, or any one may be arranged obliquely, which is not specifically limited here. In an embodiment, the substrate 1, the capillary layer 2, and the cover plate 3 are arranged parallel to each other in the direction of gravity (or the vertical direction). The bottom of the projection of the capillary layer 2 on the plane extending along the direction of gravity is not higher than the bottom of the projection of the heat source 4 mounted on the second plate surface on the plane extending along the direction of gravity, and a top of the projection of the capillary layer 2 on the plane extending along the direction of gravity is not lower than the top of the projection of the heat source 4 mounted on the second plate surface on the plane extending along the direction of gravity. That is, in order to enable the liquid phase-change working medium to fully absorb the heat of the heat source 4, the top of the capillary layer 2 is required to be at least flush with the top of the heat source 4 in the direction of gravity (or the vertical direction), that is, the projection of the heat source 4 on the plane extending along the direction of gravity (or the vertical direction) entirely falls within the capillary layer 2. In this way, even if the projection of the liquid level of the liquid phase-change working medium on the plane extending along the direction of gravity is lower than the top of the projection of the heat source 4 on the plane extending along the direction of gravity, under the action of the capillary layer, the liquid phase-change working medium can be transported to a height corresponding to the top of the heat source 4 and performs the heat transfer of phase change with the heat source 4 (the heat absorbed by the phase-change working medium comes from the heat source 4), thereby ensuring that the liquid phase-change working medium can fully absorb the heat of the heat source 4. That is to say, due to the existence of the capillary layer, the projection of the liquid level of the liquid phase-change working medium accommodated in the accommodation cavity 101 on the plane extending along the direction of gravity is not required to be higher than the top of the projection of the heat source 4 on the plane extending along the direction of gravity. That is, the projection of the capillary layer 2 on the plane extending along the direction of gravity (vertical direction) overlaps the projection of the heat source 4 on the plane extending along the direction of gravity. It can be understood that, the bottom of the capillary layer 2 is immersed in the liquid phase-change working medium in the accommodation cavity 101; the capillary layer 2 is configured to suck the liquid phase-change working medium to perform phase-change heat transfer with the heat source 4. that is, based on the capillary force of the capillary layer 2, the liquid phase-change working medium is sucked upwards to a position, corresponding to a part, at which the projection of the capillary layer 2 and the projection of the heat source 4 overlap, of the capillary layer, that is, the liquid phase-change working medium is sucked to the height corresponding to the heat source, so that heat transfer of phase change is performed between the liquid phase-change working medium and the heat source 4 to generate the gaseous phase-change working medium.

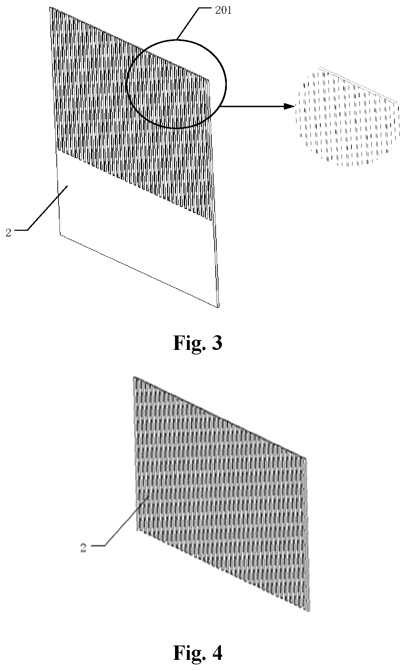

Further, for a conventional thermosiphon radiator, an evaporation boiling surface inside the thermosiphon radiator is usually a smooth wall surface, and the boiling superheat of the smooth wall surface is usually high, which also reduces the performance of the thermosiphon radiator. In an embodiment of the application, a steam channel is provided on the capillary layer 2. As shown in Figures 3 and 4, a steam channel 201 is provided on the capillary layer 2, and the steam channel 201 is configured to discharge the gaseous phase-change working medium generated by phase change from the capillary layer 2. In general, the top of the capillary layer 2 is lower than the top of the accommodation cavity 101 in the direction of gravity (or the vertical direction), and is usually flush with the top of the heat source. The steam channel 201 may be arranged on one side, facing towards the first plate surface, of the capillary layer 2, that is, the steam channel 201 is arranged on one side, closer to (facing towards) the substrate 1, of the capillary layer 2, and the steam channel 201 is arranged at a same height as that of the heat source 4 in the direction of gravity (or the vertical direction). The steam channel 201 is a continuous channel at the same height as the heat source 4 on the capillary layer 2, and the steam channel 201 may be a continuous groove extending upward. The steam channel 201 is configured to discharge the gaseous phase-change working medium generated by heat transfer of phase change to a steam space above the capillary layer 2. The steam space is mainly a space between the top of the capillary layer 2 and the top of the accommodation cavity 101. It can be understood that, after the liquid phase-change working medium becomes the gas phase-change working medium through the phase-change, the gas phase-change working medium can be quickly discharged to the steam space along the continuous groove. Without the continuous steam channel 201 (gas channel), the generated gas has to pass through the entire capillary layer 2 before the gas is discharged, which increases the resistance of the movement of the gaseous phase-change working medium and also increases the resistance of the flow of the liquid phase-change working medium in the capillary layer. Therefore, the continuous steam channel 201 is formed on the side, closer to (facing towards) the substrate 1, of the capillary layer 2, so that the generated gaseous phase-change working medium (steam) can be discharged upwards quickly. Further, the capillary layer 2 (a capillary structure) partially strengthens the boiling surface, reducing the superheat between the heat source 4 and the boiling temperature.

It can be understood that, the heat dissipation element according to the embodiment of the application is generally placed vertically when the heat dissipation element is working, and in some cases, the heat dissipation element may be allowed to be placed at a preset inclination angle, which is not limited here. The preset angle may be 15 degrees or 20 degrees, which is not limited here. When the liquid level of the liquid phase-change working medium in the accommodation cavity is lower than the top of the heat source, the liquid phase-change working medium in a lower part of the accommodation cavity is sucked upwards by utilizing the capillary force generated by the capillary layer in the accommodation cavity, the liquid phase-change working medium is transported to the height corresponding to the heat source 4, and performs heat transfer of phase change with the heat source 4.

It can be seen that, the heat dissipation element according to the embodiment of the application includes: the substrate and the cover plate connected to each other to form the accommodation cavity; and the capillary layer arranged in the accommodation cavity. The substrate has the first plate surface and the second plate surface opposite to each other, the first plate surface is configured to form the accommodation cavity, the second plate surface is configured to allow the heat source to be mounted thereon, and the projection of the liquid level of the liquid phase-change working medium accommodated in the accommodation cavity on the plane extending along the direction of gravity is not higher than the top of the projection of the heat source mounted on the second plate surface on the plane extending along the direction of gravity. The bottom of the projection of the capillary layer on the plane extending along the direction of gravity is not higher than the bottom of the projection of the heat source mounted on the second plate surface on the plane extending along the direction of gravity, and the top of the projection of the capillary layer on the plane extending along the direction of gravity is not lower than the top of the projection of the heat source mounted on the second plate surface on the plane extending along the direction of gravity. The capillary layer is configured to suck the liquid phase-change working medium to perform phase-change heat transfer with the heat source, the steam channel is provided on the capillary layer, and the steam channel is configured to discharge the gaseous phase-change working medium generated by phase change from the capillary layer. Since the projection of the liquid level of the liquid phase-change working medium accommodated in the accommodation cavity on the plane extending along the direction of gravity is not higher than the top of the projection of the heat source mounted on the second plate surface on the plane extending along the direction of gravity, the liquid phase-change working medium does not occupy the space that can be used as a condensation area. Therefore, in the thermosiphon radiator to which the heat dissipation element according to the embodiment of the application is applied, the space that can be used as the condensation area can be fully utilized, expanding the condensation space of the thermosiphon radiator, thereby improving the performance of the thermosiphon radiator. In an embodiment, a capillary layer is provided in the accommodation cavity, the liquid in the lower part of the accommodation cavity is sucked through the capillary force of the capillary layer to perform heat transfer of phase change with the heat source at a higher position. Through the capillary effect formed by the capillary structure, the liquid phase-change working medium lower than the topmost position of the heat source can be sucked to a certain height, so that the heat source at a higher position can still convert and transfer heat through heat transfer of phase change, thereby increasing a total area for heat transfer of phase change and improving the efficiency of heat transfer. The use amount of the phase-change working medium is reduced, and the two-phase space (or the condensation space) is expanded, thereby improving the heat dissipation capacity of the thermosiphon radiator to which the heat dissipation element according to the embodiment of the application is applied for a heat source at a relatively high position.

Further, in an embodiment of the application, the capillary layer 2 may be arranged as follows: the bottom of the projection of the capillary layer 2 on the plane extending along the direction of gravity is lower than the bottom of the projection of the heat source 4 mounted on the second plate surface on the plane extending along the direction of gravity. That is, the bottom of the heat source 4 is arranged above the bottom of the accommodation cavity 101 in the direction of gravity, and the projection of the liquid level of the liquid phase-change working medium accommodated in the accommodation cavity 101 on the plane extending along the direction of gravity (or the vertical direction, that is a direction perpendicular to the ground) is not higher than the top of the projection of the heat source 4 on the plane extending along the direction of gravity. The steam channel 201 of the capillary layer 2 is arranged on a part, a projection of which on the plane extending along the direction of gravity is not lower than the bottom of the projection of the heat source 4 mounted on the second plate surface on the plane extending along the direction of gravity, of the capillary layer 2. It can be understood that, in this case, the liquid phase-change working medium is sucked upwards from the bottom of the capillary layer 2 to the top of the capillary layer 2 by the capillary force, so that the entire heat source 4 can convert and transfer heat with the liquid phase-change working medium through heat transfer of phase change, the steam channel 201 can discharge the gaseous phase-change working medium generated by phase change, so as to ensure the smooth flow of the liquid phase-change working medium and the gaseous phase-change working medium.

Further, in an embodiment of the application, alternatively, the capillary layer 2 may be arranged as follows: the bottom of the projection of the capillary layer 2 on the plane extending along the direction of gravity is flush with the bottom of the projection of the heat source 4 mounted on the second plate surface on the plane extending along the direction of gravity, and the bottom of the capillary layer 2 abuts against the bottom of the accommodation cavity 101 in the direction of gravity. Meanwhile, the projection of the liquid level of the liquid phase-change working medium accommodated in the accommodation cavity 101 on the plane extending along the direction of gravity (or the vertical direction, that is, the direction perpendicular to the ground) is higher than the bottom of the projection of the heat source 4 mounted on the second plate surface but not higher than the top of the projection of the heat source 4 on the plane extending along the direction of gravity. In an embodiment, the projection of the liquid level of liquid phase-change working medium on the plane extending along the direction of gravity (or the vertical direction, that is, the direction perpendicular to the ground) is higher than the bottom of the projection of the heat source 4 but lower than the top of the projection of the heat source 4 on the plane extending along the direction of gravity. That is, the bottom of the heat source 4 is at the same height as that of the bottom of the accommodation cavity 101 in the direction of gravity. Based on the fact that the liquid level of the liquid phase-change working medium in the accommodation cavity 101 is lower than the top of the heat source 4 but higher than the bottom of the heat source 4. In this case, the capillary layer 2 can suck the liquid phase-change working medium upwards to the height corresponding to the top of the heat source 4, to fully absorb the heat of the heat source 4, and the gaseous phase-change working medium generated by the phase change is discharged through the steam channel 201 of the capillary layer 2.

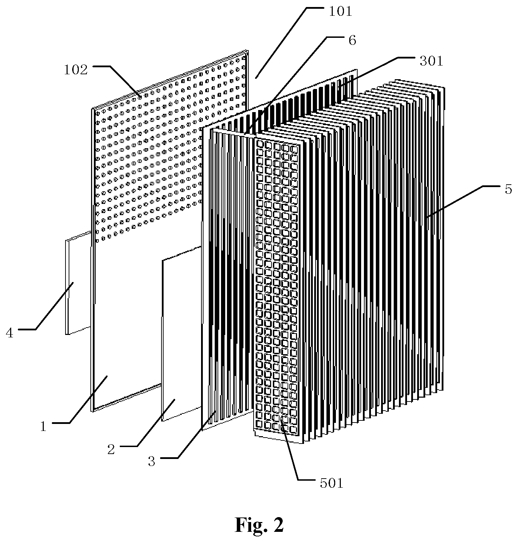

Further, as shown in Figure 2, the heat dissipation element further includes a filling tube 6. The filling tube 6 may be arranged on the substrate 1, or may be arranged on the cover plate 3, which is not specifically limited here. The position and the form of the filling tube 6 may be varied. One end of the filling tube 6 is in communication with the accommodation cavity 101, and the other end is configured to be communicated with the exterior of the heat dissipation element. That is, one end of the filling tube 6 is directed to the interior of the heat dissipation element, and the other end is directed to the exterior of the heat dissipation element. The filling tube 6 is configured to vacuumize the accommodation cavity 101 and the working-medium channel 501 and inject the liquid phase-change working medium into the accommodation cavity 101 and the working-medium channel 501. That is, the filling tube 6 is configured to vacuumize and inject liquid into all connected cavities inside the heat dissipation element, that is, the accommodation cavity 101 and the working-medium channel 501 are vacuumized and injected with the liquid phase-change working medium.

Further, the cover plate 3 includes connecting holes 301. The connecting holes 301 may be parallel elongated holes or multiple circular holes, which is not limited here. The connecting holes 301 are configured to allow the accommodation cavity 101 to be communicated with the working-medium channel 501, to allow the gaseous phase-change working medium to be diffused to the working-medium channel 501 through the connecting holes 301, and to allow the liquid phase-change working medium generated by condensation in the working-medium channel 501 to flow to the bottom of the accommodation cavity 101 through the connecting holes 301. It can be understood that, the connecting holes 301 allow the phase-change working medium to form a circulation loop between the accommodation cavity 101 and the working-medium channel 501. In addition, the accommodation cavity 101 and the working-medium channel 501 are communicated with each other through the connecting holes 301 in the cover plate 3, the phase-change working medium is injected into the accommodation cavity 101 of the heat dissipation element and can freely flow in the accommodation cavity 101 and the working-medium channel 501.

Further, a support structure is arranged on the substrate 1, the support structure is arranged on a part, a projection of which on the plane extending along the direction of gravity is higher than the top of the projection of the capillary layer 2 on the plane extending along the direction of gravity, of the first plate surface of the substrate 1. That is, the support structure is arranged on the first plate surface and above the capillary layer 2. The support structure includes multiple support columns 102 spaced apart. The cross-section of the support column 102 may be circular-shaped, triangular-shaped, quadrilateral-shaped, or shaped in other polygons, which is not limited here. One end of the support column 102 is connected to the first plate surface, and the other end is connected to the cover plate 3, so as to support the accommodation cavity 101. It can be understood that the accommodation cavity 101 is filled with the phase-change working medium. The phase-change working medium has a relatively high pressure when the phase-change working medium is working at a high temperature. When the heat source does not emit heat and the temperature is low, and the accommodation cavity 101 is in a negative pressure state during the filling process, the accommodation cavity 101 is easily deformed. The function of the support column 102 is to provide a strong enough pulling force and supporting force to ensure that the accommodation cavity 101 between the substrate 1 and the cover plate 3 is not deformed under the influence of pressure.

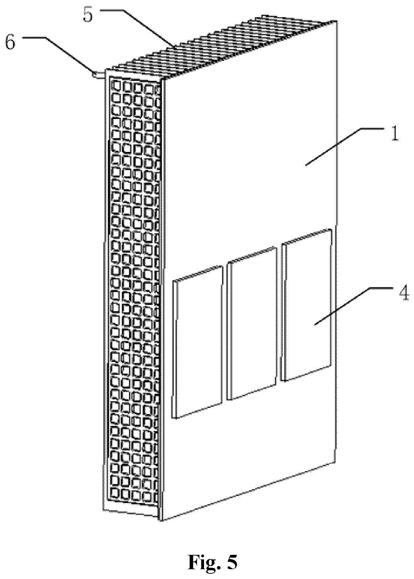

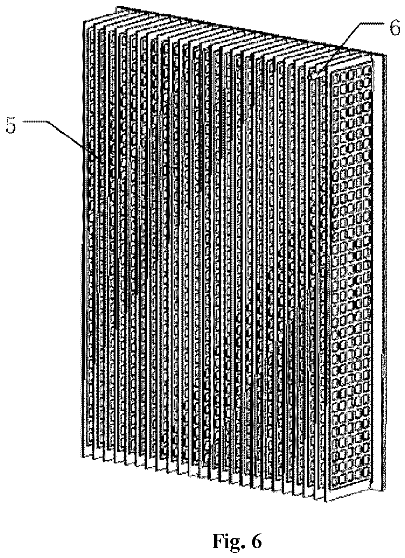

A thermosiphon radiator is further provided according to an embodiment of the application. As shown in Figures 5 and 6, the thermosiphon radiator includes a fin having a working-medium channel 501 and the heat dissipation element as described above. It can be understood that the thermosiphon radiator includes a heat dissipation fin assembly 5. The heat dissipation fin assembly 5 is arranged on one side, away from the accommodation cavity, of the cover plate 3, and the heat dissipation fin assembly 5 includes multiple fins each having a working-medium channel 501, that is, the fins are arranged on one side, away from the accommodation cavity 101, of the cover plate 3, and the working-medium channel 501 of each of the fins is in communication with the connecting holes 301. It can be understood that, each of the fins of the heat dissipation fin assembly 5 has a working-medium channel 501, to allow the gaseous phase-change working medium generated by heat transfer of phase change to condense into the liquid phase-change working medium in the working-medium channel 501. The working-medium channel 501 can be understood as an internal channel of the fin of the heat dissipation fin assembly 5, the fin may be formed by welding two pieces of metal, and the internal channel (i.e. the working-medium channel 501) is formed between the two pieces of metal. It can be understood that the gaseous phase-change working medium generated by heat transfer of phase change enters the working-medium channel 501 of the heat dissipation fin assembly 5 of the thermosiphon radiator and can be condensed into the liquid phase-change working medium. As an extended heat dissipation surface, the fin exchanges heat with the environment, thereby reducing the surface temperature of the fin, so that the gaseous phase-change working medium can be condensed in the working-medium channel 501 of the fin, and can flow to a lower part of the fin under the action of gravity, so as to flow back to the accommodation cavity 101.

Further, in the thermosiphon radiator according to the embodiment of the application, the substrate 1 and the capillary layer 2, the substrate 1 and the cover plate 3, and the cover plate 3 and the fin are fixed to each other by welding. That is, the substrate 1, the capillary layer 2, the cover plate 3, and the fin of the heat dissipation fin assembly 5 may be connected to respective objects by welding.

In an embodiment of the application, parts of the radiator are assembled together by welding. Through the filling tube 6, air in all communicated cavities in the radiator is discharged, and the phase-change working medium is injected into the cavities. When the heat source 4 generates heat, the phase of the liquid phase-change working medium in the radiator is changed by boiling, the heat of the heat source is absorbed by utilizing latent heat of vaporization. Meanwhile, the liquid phase-change working medium is transformed into the gaseous phase-change working medium. The liquid level of the liquid phase-change working medium is lower than the top of the heat source 4. Through the capillary force of the capillary layer 2 in the accommodation cavity 101, the liquid phase-change working medium can be sucked upwards to the height corresponding to the top of the heat source 4, and heat transfer of phase change is performed between the liquid phase-change working medium and the heat source 4, and the high-temperature gaseous phase-change working medium is discharged into the steam space above the capillary layer 2. The high-temperature gaseous phase-change working medium generated at the heat source 4 is in a high-pressure state, and is diffused into the working-medium channel 501 of the heat dissipation fin assembly 5 through the connecting holes 301 of the cover plate 3 under the drive of pressure. When the gas phase-change working medium with a relatively high temperature contacts the inner surface of the fin in the working-medium channel 501, the gaseous phase-change working medium is condensed on a cold wall surface to become the liquid phase-change working medium, and heat is released. The process of quickly transferring the heat of the heat source 4 to the heat dissipation fin is completed. The condensed liquid phase-change working medium flows downwards along the inner wall of the heat dissipation fin under the action of gravity, and thus the circulation of the phase-change working medium is completed.

Finally, it should be noted that the above embodiments are only used to illustrate the technical solutions of the embodiments of the application, and are not intended to be limitation; although the embodiments of the application have been described in detail with reference to the foregoing embodiments, those skilled in the art should understand that the technical solutions described in the foregoing embodiments may still be modified, or some or all of the technical features may be equivalently replaced; these modifications or replacements do not make the essences of the corresponding technical solutions depart from the scope of the technical solutions of the embodiments of the application, and should all be covered within the scope of the claims and the description of the application.

## Claims

1. A heat dissipation element, applied to a thermosiphon radiator, comprising:
a substrate and a cover plate connected to each other to form an accommodation cavity, wherein the accommodation cavity is configured to accommodate a phase-change working medium and be communicated with a working-medium channel in a fin of the thermosiphon radiator, wherein
the substrate has a first plate surface and a second plate surface opposite to each other, the first plate surface is configured to form the accommodation cavity, the second plate surface is configured to arrange a heat source, and a projection of a liquid level of a liquid phase-change working medium accommodated in the accommodation cavity on a plane extending along a direction of gravity is not higher than a top of a projection of the heat source mounted on the second plate surface on the plane extending along the direction of gravity; and
a capillary layer arranged in the accommodation cavity, wherein a bottom of a projection of the capillary layer on the plane extending along the direction of gravity is not higher than a bottom of the projection of the heat source mounted on the second plate surface on the plane extending along the direction of gravity, and a top of the projection of the capillary layer on the plane extending along the direction of gravity is not lower than the top of the projection of the heat source mounted on the second plate surface on the plane extending along the direction of gravity, wherein
the capillary layer is configured to suck the liquid phase-change working medium to perform phase-change heat transfer with the heat source, a steam channel is provided on the capillary layer, and the steam channel is configured to discharge a gaseous phase-change working medium generated by phase change from the capillary layer.

2. The heat dissipation element according to claim 1, wherein
the bottom of the projection of the capillary layer on the plane extending along the direction of gravity is lower than the bottom of the projection of the heat source mounted on the second plate surface on the plane extending along the direction of gravity; and
the steam channel is arranged on a part, a projection of which on the plane extending along the direction of gravity is not lower than the bottom of the projection of the heat source mounted on the second plate surface on the plane extending along the direction of gravity, of the capillary layer.

3. The heat dissipation element according to claim 1, wherein
the bottom of the projection of the capillary layer on the plane extending along the direction of gravity is flush with the bottom of the projection of the heat source mounted on the second plate surface on the plane extending along the direction of gravity; and
a bottom of the capillary layer abuts against a bottom of the accommodation cavity in the direction of gravity.

4. The heat dissipation element according to any one of claims 1 to 3, wherein the steam channel is arranged on one side, facing towards the first plate surface, of the capillary layer.

5. The heat dissipation element according to claim 1, further comprising a filling tube; wherein
one end of the filling tube is in communication with the accommodation cavity, and the other end of the filling tube is configured to be communicated with an exterior of the heat dissipation element; and
the filling tube is configured to vacuumize the accommodation cavity and the working-medium channel and inject the liquid phase-change working medium into the accommodation cavity and the working-medium channel.

6. The heat dissipation element according to claim 1, wherein
connecting holes are formed in the cover plate, wherein
the connecting holes are configured to allow the accommodation cavity to be communicated with the working-medium channel to allow the gaseous phase-change working medium to be diffused into the working-medium channel through the connecting holes, and to allow the liquid phase-change working medium condensed in the working-medium channel to flow back to the accommodation cavity through the connecting holes.

7. The heat dissipation element according to claim 1, wherein
a support structure is arranged on the substrate, wherein
the support structure is arranged on a part, a projection of which on the plane extending along the direction of gravity is higher than the top of the projection of the capillary layer on the plane extending along the direction of gravity, of the first plate surface;
the support structure comprises a plurality of support columns spaced apart; and
one end of each of the plurality of support columns is connected to the first plate surface, and the other end of each of the plurality of support columns is connected to the cover plate to support the accommodation cavity.

8. The heat dissipation element according to claim 7, wherein a cross section of the support column is circular-shaped or polygonal-shaped.

9. The heat dissipation element according to claim 1, wherein the capillary layer comprises any one of: a capillary product formed by sintering metal powders with different particle sizes, a capillary product formed by sintering multiple layers of mesh structures, a capillary product formed by 3D metal printing, or a metal foam.

10. The heat dissipation element according to claim 1, wherein the liquid phase-change working medium comprises any one of: an R134a working medium, an R22 working medium, an R1233zd working medium, or a fluorinated liquid.

11. A thermosiphon radiator, comprising:
a fin having a working-medium channel; and
the heat dissipation element according to any one of claims 1-10, whereinthe fin is arranged on one side, away from the accommodation cavity, of the cover plate, and the working-medium channel is in communication with the connecting holes.

12. The thermosiphon radiator according to claim 11, wherein the substrate and the capillary layer, the substrate and the cover plate, and the cover plate and the fin are fixed to each other by welding.
